# EUROPEAN PATENT APPLICATION

(11) **EP 0 981 220 A2**
(43) Date of publication of application: **23.02.2000**
(21) Application number: 99304809.9
(22) Date of filing: 18.06.1999
(51) Int. Cl.: H04L 1/00

(54) **Method and apparatus for encoding rate control information in a data transmission system**

(30) Priority: 22.06.1998 FI 981435
(71) Applicant: NOKIA MOBILE PHONES LTD., 02150 Espoo (FI)
(72) Inventor: Pehkonen, Kari, Setagaya-ku, Tokyo, 154-0012 (JP)
(74) Representative: Higgin, Paul

(57) **Abstract**

The invention relates to a data transmission system and method for encoding a signal to be transmitted in a data transmission system, the method allowing data to be transmitted at various different transmission rates, data being transmitted in the method in frame format, the frames (100) also comprising information about the used transmission rate, conveyed by means of control bits (106), the control bits being encoded by using a biorthogonal coding to provide encoded bits. To allow the transmission rate used in a frame to be flexibly indicated, the used biorthogonal coding depends on the number of the different transmission rates and the encoding is selected so that the number of encoded bits remains constant.

## Description

The invention relates to a data transmission system and a method for encoding a signal to be transmitted in the data transmission system, which allows data to be transmitted at various different transmission rates. The data are transmitted in frame format, the frames also comprising information of the used transmission rate. The invention relates to the implementation of encoding of control bits indicating transmission rate.

The demands on data transmission systems are continuously growing. This particularly concerns wireless data transmission systems, such as cellular radio systems, which are expected to provide increasingly diverse services, e.g. various kinds of data and video services.

Wireless data transmission systems have conventionally only been used for the transmission of speech. The increased number of various services to be transmitted signifies, in wireless systems in particular, that the system must be able to transfer signals of different capacity over the radio path; speech at a data transfer rate of 8 kbit/s and data at a rate of 64 kbit/s, for example. In addition, signals of different quality of service levels need to be transmitted, such signals typically requiring also different transmission rates simultaneously. A typical example that can be mentioned is a video connection where the picture requires high data transmission rate and high quality of service, whereas sound can be transferred at a lower rate and lower quality of service. A data transmission system should therefore be able to operate effectively in an environment in which transmissions of various different data transmission rates, quality of service levels and service types are conveyed.

In digital data transmission systems in particular signals are typically transmitted in frame format. In many cases a frame can be further divided into a plural number of time slots. In systems where data can be transmitted at various different transmission rates, the transmission rate used for any given transmission unit, whether it is a frame or a slot, must be somehow detected by the receiver. One solution is to send explicit control information which indicates the transmission rate of each transmission unit to the receiver.

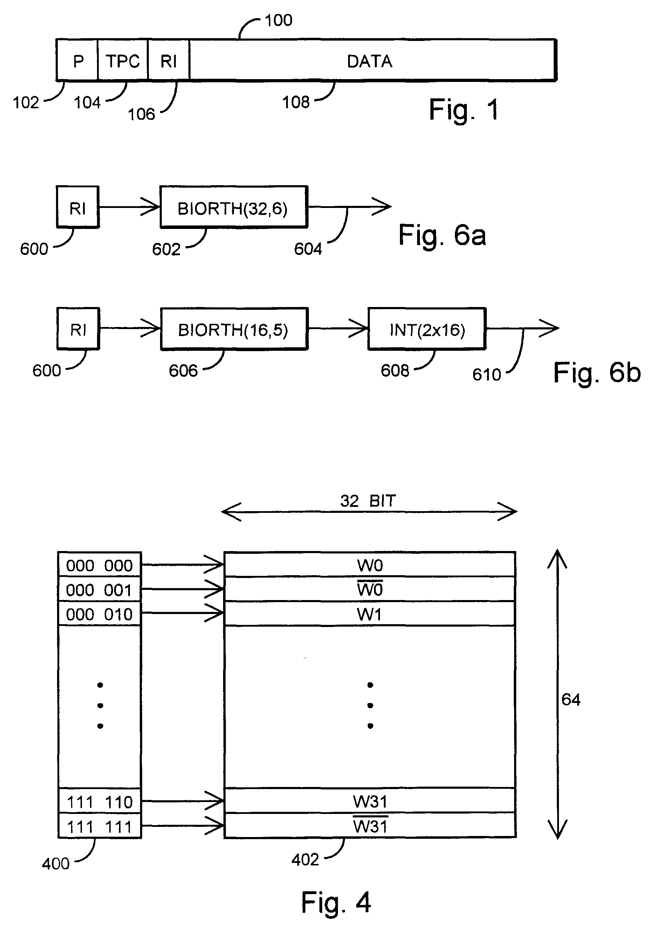

Figure 1 illustrates a typical time slot 100 of a prior art frame. A time slot typically comprises one or more fields 102-106 conveying various control information, such as a pilot signal 102, power control information 104 and control bits indicating the data transmission rate used in the frame. The time slot further comprises a field 108 conveying the actual information. The time slot is conveyed as a single physical packet on a transmission channel, whereas control information fields can be conveyed on a separate logical channel. In this example the fields 102-106 conveying control information are transferred on a logical control channel and the field 108 conveying the actual data on a logical data channel.

The size of the time slots conveying control information is limited. A known method of indicating the data transmission rate used per time slot is to encode rate information (RI) bits by using a biorthogonal code, i.e. to map the bits by applying Walsh functions. Let us assume, by way of example, that the number of RI bits is N_{RI}. They can thus be used for expressing 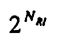 different transmission rates. Let us assume that N_{RI} = 6, for example. In this case (32.6) biorthogonal coding is used, i.e. 32-bit Walsh functions and their binary complements, thus providing 64 code words. The RI field thus occupies 32 bits in the frame, so it can be used for indicating 64 different transmission rates.

Usually the aim is to keep the number of control bits per time slot small. If there is a larger number of transmission rates, or their number varies greatly, prior art methods have difficulties in indicating the transmission rate in the limited number of RI bits. A natural alternative is to introduce a new code word, i.e. to increase the number of the RI bits to twelve. This would, however, change the time slot structure, which is not desirable because the actual data would then have less space and significant changes to the system would be caused. In addition, varying transmission rates may cause situations in which the number of the RI bits is unnecessarily high and time slot capacity is wasted.

The invention seeks to provide a method whereby the above problems in indicating transmission rate can be solved. This is achieved with a method of the invention for encoding a signal in a data transmission system, the method allowing data to be transmitted at various different transmission rates, the data being transmitted in the method in frame format, the frames also comprising information of the used transmission rate, conveyed by means of control bits, the control bits being encoded by using a biorthogonal coding to provide encoded bits. The method of the invention is characterized in that the biorthogonal coding used depends on the number of the different transmission rates and that the encoding is selected so that the number of encoded bits remains constant.

The method of the invention is further characterized in that the number of transmission rates available is determined; the number of control bits needed is determined on the basis of the number of the transmission rates; the biorthogonal coding used is determined on the basis of the number of the control bits; and the encoding is selected so that the number of encoded bits remains constant.

The invention further relates to a data transmission system allowing data to be transmitted at various different transmission rates, the data being transmitted in the system in frame format, the frames also comprising information about the used transmission rate, conveyed by means of control bits, the control bits being encoded by using a biorthogonal coding to provide encoded bits. The system of the invention is characterized in that the biorthogonal coding used in the system depends on the number of the different transmission rates and that the encoding used is selected so that the number of encoded bits remains constant.

The system of the invention is further characterized in that the number of transmission rates available is determined in the system; the number of control bits needed is determined on the basis of the number of the transmission rates; and that the biorthogonal coding used is selected on the basis of the number of the control bits; and that the encoding is selected so that the number of encoded bits remains constant.

The preferred embodiments of the invention are disclosed in the dependent claims.

The method and system of the invention provide various advantages. An exactly suitable number of control bits can be selected because the encoding is adaptive, thus allowing control bits to be encoded to the frame structure provided. The frame structure itself remains unchanged.

In the following the invention will be described in greater detail, by way of one example, with reference to the attached drawings, in which
Figure 1 illustrates an example of the data transmission time slot already described;
Figure 2 illustrates an example of a data transmission system to which the invention can be applied;
Figure 3 illustrates an example of a transmitter of the data transmission system;
Figure 4 illustrates an example of encoding;
Figures 5a and 5b illustrate the use of two code words; and
Figures 6a and 6b illustrate another example of encoding.

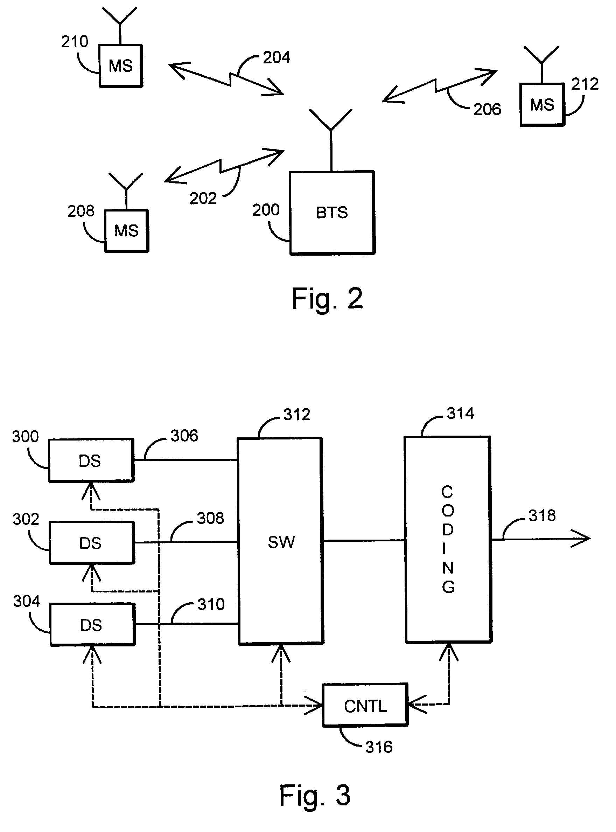

Figure 2 illustrates a digital data transmission system to which the solution of the invention can be applied. The system concerned is part of a cellular radio system comprising a base station 200 having a bidirectional connection 202-206 to subscriber terminals 208-212. The base station further communicates with a base station controller 214, which relays subscriber terminal connections to other parts of the network. As the digital data transmission system used as an example is a cellular radio system, the invention will be described in the following when applied to a cellular radio system without, however, in any way restricting it thereto, as will be apparent to a person skilled in the art. The invention can also be applied to other systems.

Let us assume that subscriber terminals in the system can transmit information at various different data transmission rates, depending on the data transmission capacity needed in each case. Figure 3 is a block diagram illustrating a possible structure of a transmitter implementing the solution of the invention. The transmitter comprises a group of data sources 300-304, which are provided for speech transmission or for different data services, for example. In the data sources, information is channel coded. Signals 306-310 in the sources are of a frame format and their data transmission rates differ from one another. The transmitter also comprises a switch or multiplexer 312 which selects or connects a signal from one or more currently active data sources further to coding means 314. Control means 316 control the operation of the switch or multiplexer 312 and the other parts of the transmitter. The control and coding means 314, 316 are most advantageously implemented by software, using a processor. A signal 318 leaving the coding means 314 is of a frame format. In the coding means 314 the data transmission rates of the signals from the data sources are adapted to fit into a frame by using either a repeat or a removal coding. It should be noted that the transmitter in Figure 3 only comprises components essential for the description of the invention. A real transmitter comprises also other components, such as filters and amplifiers, known to a person skilled in the art, but for clarity they are not described here.

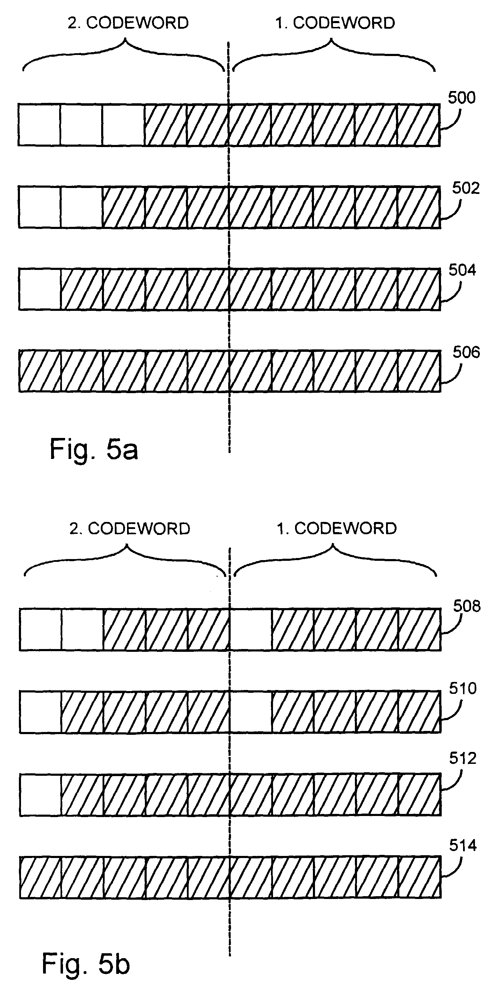

The coding means 314 thus generate the frame to be transferred and add the control bits to the frame. The RI bits indicating the data transmission rate to be used in the frame are also added to the frame. In a solution of the invention the channel coding of the RI bits depends on the number of the RI bits. This will be examined in greater detail with reference to Figures 4, 5a and 5b.

The rate information (RI) bits are encoded by using a biorthogonal code, i.e. the bits are mapped by applying Walsh functions. Let us assume that the number of RI bits is N_{RI}. They can thus be used for expressing 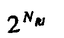 different transmission rates. Let us assume that N_{RI} = 6, for example. In this case (32.6) biorthogonal coding is used, i.e. 32-bit Walsh functions and their binary complements, thus providing 64 code words. The RI field thus occupies 32 bits in the frame, so it can be used for indicating 64 different transmission rates. This is illustrated in Figure 4, in which the RI bits 400 are unambiguously mapped by means of 32-bit Walsh functions 402.

If there are more than 6 RI bits, the method shown in Figure 4 is not possible without the structure of the frame being changed in such a way that the control field is extended to the length of 2*32 = 64 bits. In the solution of the invention this drawback is avoided by changing the biorthogonal coding of the RI bits. When the length of the Walsh function is shortened to 16 bits, for example, it is possible to show, by means of (16.5) biorthogonal coding, 10 RI bits in a 32-bit field. In this case the RI bits are mapped by means of two 16-bit Walsh functions. Further, if there are 11-16 RI bits, the length of the Walsh functions can be determined to be 8. This provides four 8-bit code words. The table below illustrates the different alternatives.

| **No. of RI bits** | **Walsh function length** | **No. of code words per frame** |
|---|---|---|
| 1-6 | 32 | 1 |
| 7-10 | 16 | 2 |
| 11-16 | 8 | 4 |

Let us examine in greater detail a case of 7-10 RI bits, which can thus be mapped by means of (16.5) biorthogonal coding, the RI bits being mapped by using two 16-bit code words, or Walsh functions. The RI bits can be distributed in various ways to the code words as illustrated in Figures 5a and 5b. In the example shown in Figure 5a the control bits to be encoded are distributed to the different code words in such a way that as many bits as possible are encoded by using the first code words, the last code word being used for the remaining bits. A frame 500 in Figure 5a comprises 7 encoded RI bits, a frame 502 comprises 8 encoded RI bits, a frame 504 comprises 9 encoded RI bits and a frame 506 comprises 10 encoded RI bits. Another option is to evenly distribute the bits to the different code words as shown in Figure 5b. In Figure 5b, a frame 508 comprises 7 encoded RI bits, a frame 510 comprises 8 encoded RI bits, a frame 512 comprises 9 encoded RI bits and a frame 514 comprises 10 encoded RI bits. This is a slightly more complex implementation, but with 7-9 bits it provides a better performance. The reason for the improved performance is that since all the various combinations available are not used in the encoding, the Walsh functions can be selected so that decoding error is minimum.

Figures 6a and 6b further illustrate a preferred encoding of the RI bits. If there are 1-6 RI bits, the operation proceeds according to Figure 6a in which bits 600 are encoded by means of biorthogonal (32.6) coding 602, the encoded bits 604 then being mapped onto a physical channel. If there are 7-10 RI bits, the operation proceeds according to Figure 6b in which the bits 600 are encoded by means of biorthogonal (16.5) coding 606, the encoded bits then being interleaved 608 after which the interleaved bits 610 are mapped onto a physical channel. It is to be observed that the described interleaving is only one example and that other alternatives are also possible.

Even though the invention is described above with reference to an example shown in the attached drawings, it is apparent that the invention is not restricted to it, but can vary in many ways within the inventive idea disclosed in the attached claims.

## Claims

1. A method for encoding a signal to be transmitted in a data transmission system, the method allowing data to be transmitted at various different transmission rates, the data being transmitted in the method in frame format, the frames (100) also comprising information of the used transmission rate, conveyed by means of control bits (106), the control bits being encoded by using a biorthogonal coding to provide encoded bits, **characterized** in that the biorthogonal coding used depends on the number of the different transmission rates and that the encoding is selected so that the number of encoded bits remains constant.

2. A method for encoding a signal to be transmitted in a data transmission system, the method allowing data to be transmitted at various different transmission rates, the data being transmitted in the method in frame format, the frames (100) also comprising information about the used transmission rate, conveyed by means of control bits (106), the control bits being encoded by using a biorthogonal coding to provide encoded bits, **characterized** in that the number of transmission rates available is determined;
the number of control bits needed is determined on the basis of the number of the transmission rates;
the biorthogonal coding used is determined on the basis of the number of the control bits;
and the encoding is selected so that the number of encoded bits remains constant.

3. A method according to claim 1 or 2, **characterized** in that in connection with control bit encoding, the control bits are mapped by using code words generated by Walsh functions and their binary complements.

4. A method according to claim 3, **characterized** in that as the number of control bits increases too high to be mapped by means of the code words used, the length of the code words used in encoding is halved and the control bits are mapped by using a plural number of code words.

5. A method according to claim 4, **characterized** in that the control bits to be encoded are evenly distributed to the different code words.

6. A method according to claim 4, **characterized** in that the control bits to be encoded are distributed to the different code words in such a way that as many bits as possible are encoded by using the first code words, the last code word being used for the remaining bits.

7. A data transmission system allowing data to be transmitted at various different transmission rates, the data being transmitted in the system in frame format, the frames (100) also comprising information about the used transmission rate, conveyed by means of control bits (106), the control bits being encoded by using a biorthogonal coding to provide encoded bits, **characterized** in that the biorthogonal coding used in the system depends on the number of the different transmission rates and that the encoding used is selected so that the number of encoded bits remains constant.

8. A data transmission system allowing data to be transmitted at various different transmission rates, the data being transmitted in the system in frame format, the frames (100) also comprising information about the used transmission rate, conveyed by means of control bits (106), the control bits being encoded by using a biorthogonal coding to provide encoded bits, **characterized** in that the number of transmission rates available is determined in the system; the number of the control bits needed is determined on the basis of the number of the transmission rates; and that the biorthogonal encoding used is selected on the basis of the number of the control bits; and that the encoding is selected so that the number of encoded bits remains constant.

9. Apparatus for transmitting data at different transmission rates, the apparatus comprising means arranged to use biorthogonal coding to encode control bits indicative of the transmission rate of the data, and means for selecting a biorthogonal coding from a plurality of biothogonal codings wherein different biorthogonal codings are selected for different transmission rates so that the number of encoded bits remains constant.
